Europäisches Patentamt

European Patent Office

Office européen des brevets

(11) Numéro de publication: **0 376 383 B1**

## FASCICULE DE BREVET EUROPEEN

(45) Date de publication de fascicule du brevet: **29.09.93** (51) Int. Cl.⁵: **H03K 17/66**

(21) Numéro de dépôt: **89203256.6**

(22) Date de dépôt: **20.12.89**

(54) Circuit intégré comprenant un générateur de courant commutable.

(30) Priorité: **30.12.88 FR 8817501**

(43) Date de publication de la demande:
**04.07.90 Bulletin 90/27**

(45) Mention de la délivrance du brevet:
**29.09.93 Bulletin 93/39**

(84) Etats contractants désignés:
**DE FR GB IT NL**

(56) Documents cités:
**EP-A- 0 117 508**
**EP-A- 0 223 259**

(73) Titulaire: **PHILIPS COMPOSANTS**
**4, rue du Port aux Vins**
**F-92150 Suresnes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Barbu, Stéphane**
**Société Civile S.P.I.D. 209 rue de l'Université**
**F-75007 Paris(FR)**
Inventeur: **Morisson, Richard**
**Société Civile S.P.I.D. 209 rue de l'Université**
**F-75007 Paris(FR)**

(74) Mandataire: **Charpail, François et al**
**Société Civile S.P.I.D. 156, Boulevard Haussmann**
**F-75008 Paris (FR)**

## Description

La présente invention a pour objet un circuit intégré comprenant un générateur de courant commutable présentant au moins un premier état de fourniture du courant et un deuxième état de haute impédance.

On connait déjà de l'art antérieur de telles sources de courant commutables (en particulier mettant en oeuvre des amplificateurs en classe A à charge active), mais elles ont pour inconvénient de nécessiter la commutation d'au moins un transistor pnp. En effet, les sources qui fournissent du courant sont à transistor(s) pnp, et celles qui tirent du courant sont à transistor(s) npn, ceci étant nécessaire pour garantir un courant débité ou absorbé parfaitement contrôlé et indépendant de la charge. Or, dans les circuits intégrés, les transistors npn sont toujours beaucoup plus rapides en commutation.

Le document EP-A-0 223 259 décrit un générateur de courant commutable produisant un courant en accord avec la polarité d'un signal d'entrée qui utilise deux miroirs de courants, une source de courant de référence et deux circuits de commutation réalisés par des transistors npn.

L'invention a pour objet un circuit intégré présentant une source de courant commutable du type précité dans lequel la fonction de commutation est assurée à l'aide uniquement de transistors npn, de manière à obtenir une vitesse élevée de commutation.

Le circuit selon l'invention est ainsi caractérisé en ce qu'il comporte un premier étage comprenant un miroir de courant présentant une première et une deuxième branches fournissant respectivement un premier et un deuxième courant sensiblement de même intensité et un deuxième étage, du type différentiel, et comportant un premier et un deuxième transistor de type npn dont les émetteurs sont connectés entre eux ainsi qu'à une première source de courant d'intensité donnée et dont les collecteurs sont connectés respectivement auxdites première et deuxième branches du miroir de courant, le collecteur du premier transistor constituant la sortie du générateur de courant commutable, en ce qu'il comporte une deuxième source de courant commandable présentant un troisième transistor de type npn et connectée aux émetteurs des premier et deuxième transistors, ladite deuxième source de courant présentant un état de fourniture de courant et un état inactif, en ce qu'il comporte un circuit de commutation agencé pour, dans le premier état, mettre la deuxième source de courant en état inactif, et pour déséquilibrer le deuxième étage de manière à ce que le premier transistor soit pratiquement en état de non-conduction, et dans le deuxième état, mettre la deuxième source de courant en état de fourniture de courant, et mettre le deuxième étage en état d'équilibre et en ce que la première et la deuxième source de courant ont sensiblement la même intensité.

Les seules commutations sont ainsi celles de transistors npn (deuxième source de courant, deuxième étage), le fait que la première et la deuxième source de courant ont sensiblement la même intensité permettant de maintenir sensiblement constant le courant dans les transistors pnp du miroir de courant.

Selon un mode de réalisation avantageux, les bases des premier et deuxième transistors sont reliées à une source de tension de référence à travers respectivement une première et une deuxième résistance, le générateur comporte une troisième source de courant commandable de type npn connectée à la base du premier transistor et présentant un état de fourniture de courant et un état inactif, et le circuit de commutation comporte un moyen pour commander la troisième source de courant de manière à la mettre dans son état de fourniture de courant dans ledit premier état, et la mettre en son état inactif dans ledit deuxième état.

Le déséquilibre du deuxième étage peut être avantageusement choisi pour que le premier transistor ne soit pas entièrement bloqué, tout en assurant un blocage efficace du passage du premier courant. De la sorte, le passage du premier au deuxième état est extrêmement rapide.

Selon un mode de réalisation préféré, correspondant à une commutation selon trois états, le circuit de commutation commandable de type npn présente un état de fourniture de courant et un état inactif et comporte une quatrième source de courant connectée au collecteur du premier transistor.

Selon un mode de réalisation préféré, le circuit de commutation est agencé pour que, dans le troisième état, la deuxième et la quatrième source de courant soient en état de connexion, et le deuxième étage soit en état d'équilibre. L'intensité de la quatrième source de courant peut être sensiblement égale à celle de la première source de courant.

Selon une variante, le circuit de commutation est agencé pour que, dans le troisième état, la deuxième source de courant soit en état inactif, que le deuxième étage soit en état de déséquilibre, et que la quatrième source de courant soit en état de fourniture de courant. Le courant de la quatrième source de courant peut être sensiblement égal au double de celui de la première source de courant.

Une source de courant commandable peut être un convertisseur numérique-analogique à transistors npn et à sortie de courant.

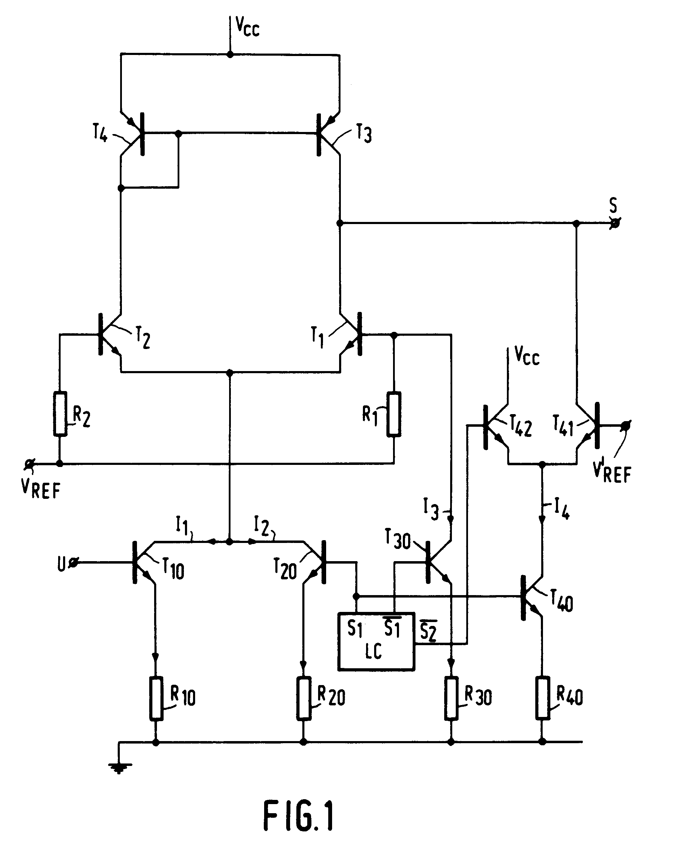

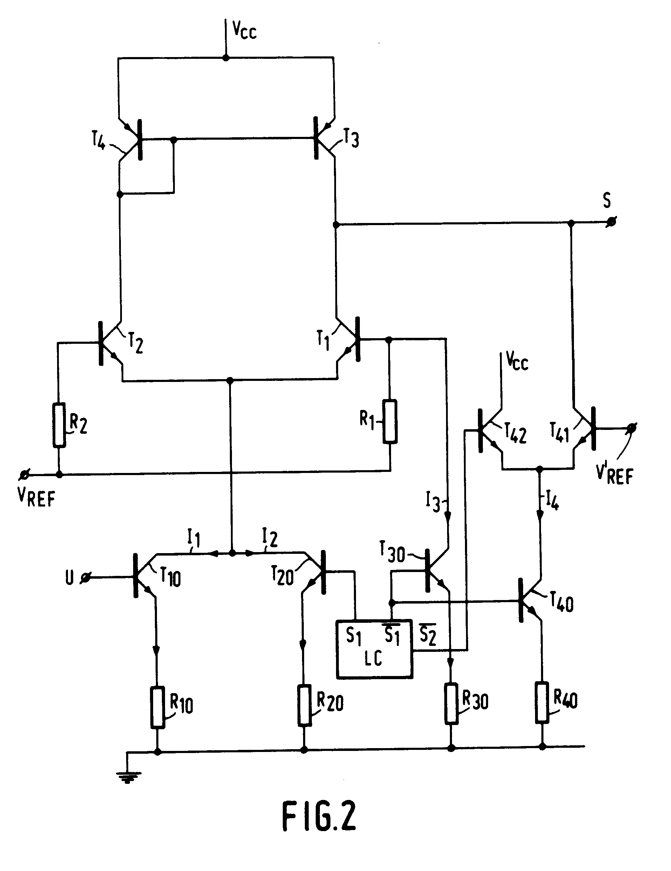

L'invention sera mieux comprise à la lecture de la description qui va suivre en liaison avec la figure 1, qui représente un mode de réalisation préféré de l'invention, et la figure 2, une variante de l'invention.

Selon la figure, un miroir de courant à deux transistors, du type Widlar présente deux transistors pnp $T_3$ et $T_4$ dont les émetteurs sont connectés à une source de tension d'alimentation $V_{cc}$, dont les bases sont interconnectées, la base et le collecteur du transistor $T_4$ étant interconnectés. On obtient ainsi des courants sensiblement identiques délivrés par les collecteurs des transistors $T_3$ et $T_4$, ce premier étage constituant donc un miroir de courant à deux branches. Pour plus de détail sur ce type de miroir de courant, et sur d'autres types de miroirs de courant, on pourra se reporter à l'ouvrage "Analysis and Design of Analog Integrated Circuits" de Gray et Meyer ($2^{ème}$ trimestre 1984 John WILEY AND SONS, Editeurs).

Les courants fournis par ce premier étage alimentent un deuxième étage npn, du type différentiel, à partir duquel sont réalisées les commutations. Ce deuxième étage compte deux transistors $T_1$ et $T_2$ couplés par les émetteurs et dont les collecteurs sont connectés respectivement à ceux des transistors $T_3$ et $T_4$. Les émetteurs interconnectés des transistors $T_1$ et $T_2$ sont connectés à une source de courant d'intensité $I_1$ constituée par un transistor $T_{10}$ dont la base est portée à un potentiel donné U, dont le collecteur est connecté aux émetteurs des transistors $T_1$ et $T_2$ et dont l'émetteur est relié au pôle de mode commun par une résistance $R_{10}$. Les bases des transistors $T_1$ et $T_2$ sont reliées à une source de tension de référence $V_{REF}$ à travers des résistances $R_1$ et $R_2$ dont les valeurs sont choisies pour que l'étage différentiel soit équilibré (à savoir $R_1 = R_2$ sauf à tenir compte des dispersions). Une deuxième source de courant présentant un transistor $T_{20}$ dont le collecteur est connecté aux émetteurs des transistors $T_1$ et $T_2$, dont l'émetteur est relié au pôle de mode commun par une résistance $R_{20}$, est commandé par un signal logique $S_1$ fourni par un circuit logique de commande LC. Lorsque $S_1$ est au niveau haut la source de courant ($R_{20}$, $T_{20}$) est active avec un courant d'intensité $I_2$.

Le déséquilibre de l'étage différentiel ($T_1$, $T_2$) est obtenu à l'aide d'une source de courant présentant un transistor $T_{30}$ npn dont le collecteur est connecté à la base du transistor $T_1$, dont l'émetteur est relié au pôle de mode commun par une résistance $R_{30}$ et dont la base est attaquée par le signal $\overline{S_1}$, inverse logique de $S_1$, délivré par le circuit logique de commande LC. Lorsque $\overline{S_1}$ est au niveau haut, la source de courant $T_{30}$ tire un courant $I_3$, ce qui a pour effet d'abaisser le potentiel de la base du transistor $T_1$ et donc de la bloquer progressivement. On choisit $R_1 I_3$ suffisamment petit (environ 300mV) pour que le passage du courant

dans le transistor $T_1$ soit négligeable, sans toutefois le bloquer complètement. A l'état d'équilibre de l'étage différentiel, le transistor $T_1$ n'est pas non plus à l'état saturé. On reste donc pratiquement dans la zone linéaire de fonctionnement d'un étage différentiel, ce qui optimise le temps de commutation entre le premier et le deuxième état. On pourrait bien entendu faire travailler $T_1$ entre blocage et saturation, mais le temps de commutation serait plus long, tout en restant largement inférieur au temps de commutation d'un transistor pnp.

Le fonctionnement de circuit est alors le suivant. Lorsque $S_1$ est au niveau bas (premier état), aucun courant ne passe dans $T_{20}$. L'étage différentiel ($T_1$, $T_2$) est déséquilibré, donc le transistor $T_1$ est quasiment bloqué. Le transistor $T_4$ est traversé par le courant $I_1$, donc également le transistor $T_3$. La sortie S se comporte donc comme une source de courant fournissant un courant $I_1$.

Lorsque $S_1$ est au niveau haut (deuxième état), $T_{20}$ est traversé par le courant $I_2$. L'étage différentiel ($T_1$, $T_2$) est équilibré, ce qui fait que les transistors $T_4$ et $T_2$ d'une part et $T_3$ et $T_1$ d'autre part sont traversés par un courant

$$\frac{I_1 + I_2}{2} \; .$$

La sortie S ne débite pas de courant et se trouve en état de haute impédance. On a ainsi obtenu la commutation d'une source de courant fournissant du courant (donc à transistor pnp) en ne faisant commuter que des transistors npn. Pour $I_2 = I_1$, le courant dans les branches du miroir de courant ne varie pas. On évite donc un temps d'établissement de courant dans le miroir de courant. Si la deuxième source de courant fournissant le courant $I_2$ n'existait pas, le temps de commutation serait grevé par un temps très élevé que mettrait le miroir de courant à voir son courant chuter de moitié, donc un temps de commutation correspondant à celui de transistors pnp. La présence de $I_2$ permet de faire travailler les transistors $T_3$ et $T_4$ à courant constant.

Dans le cas où la mise en oeuvre d'un générateur de courant à trois états est souhaitée, on peut connecter à la sortie S une source de courant commandable de type npn, qui selon un mode de réalisation préféré, peut être mise en état de fourniture de courant (courant $I_4$) lorsque le générateur est en état de haute impédance ("deuxième état").

La source de courant est constituée par un transistor $T_{40}$ dont la base est attaquée par le signal $S_1$, et dont l'émetteur est relié au pôle de mode commun par une résistance $R_{40}$. Le collecteur du transistor $T_{40}$ est connecté à un circuit différentiel d'aiguillage commandé par un signal $\overline{S_2}$

fourni par le circuit logique de commande LC et qui est au niveau bas (donc $S_2 = S_1$) pour commander le troisième état (seulement lorsque $S_1 = 1$).

Le circuit d'aiguillage comporte deux transistors $T_{41}$ et $T_{42}$ couplés par les émetteurs, ceux-ci étant connectés au collecteur du transistor $T_{40}$. Le transistor $T_{41}$ reçoit sur sa base une tension de référence $V'_{REF}$ et son collecteur est connecté à la sortie S. Le transistor $T_{42}$ reçoit sur sa base le signal $\overline{S_2}$ inverse logique de $S_2$ et son collecteur est connecté à la source de tension d'alimentation Vcc. Lorsque $S_1 = 0$, la source de courant ($R_{40}$, $T_{40}$) est inactive ; en outre $S_2 = 0$, dont $T_{41}$ est bloqué. Lorsque $S_1 = 1$, la source de courant ($T_{40}$, $R_{40}$) est traversée par un courant $I_4$. Si $S_2 = 0$, $T_{42}$ conduit et est traversé par le courant $I_4$. Si $S_2 = 1$, $T_{42}$ est bloqué, $T_{41}$ conduit, et le générateur se comporte comme une source de courant tirant un courant $I_4$. On peut choisir $I_4 = I_1$. Au moins une des sources de courant commandables peut être commandée numériquement. Autrement dit, elle peut être constituée par un convertisseur numérique-analogique à transistors npn et à sortie en courant. Ceci permet d'obtenir des niveaux nominaux du courant multiples par exemple pour un système adaptatif (commutation rapide entre les états, variation lente des niveaux nominaux des courants).

La figure 2 se différencie da la figure 1 par le fait que la base du transistor $T_{40}$ est connectée à la sortie $\overline{S_1}$ du circuit logique de commande LC, et $I_4$ est choisi sensiblement égal à $2I_1$ au cas où on souhaite l'égalité entre le courant fourni et le courant absorbé. Dans l'état de haute impédance ($S_1 = 1$, $\overline{S_1} = 0$), la source de courant ($R_{40}$, $T_{40}$) est inactive. Dans l'autre état correspondant à $S_1 = 0$ ($\overline{S_1} = 1$), le signal $\overline{S_2}$ commande soit un état de débit de courant ($\overline{S_2} = 0$), S débitant le courant $I_1$, soit un état absorbeur de courant ($\overline{S_2} = 1$), S absorbant le courant $I_4 - I_1 \simeq I_1$.

L'invention, en particulier dans sa variante à trois états, s'applique tout particulièrement à un système de verrouillage de niveau mettant en oeuvre la charge, la décharge, (avec un courant de même valeur absolue de préférence), ou l'état stationnaire, d'un élément capacitif, en particulier pour un tuner TV (circuit dit de "clamp").

On rappelera que, pour obtenir des courants $I_2$ et $I_4$ de valeur différente (fig.1) ou $I_3$ et $I_4$ de valeur différente (fig. 2) avec une même valeur de tension de base des transistors correspondants, il suffit de donner des dimensions différentes à ceux-ci ($T_{20}$ et $T_{40}$ pour la fig. 1, $T_{30}$ et $T_{40}$ pour la fig. 2).

D'autres modifications pourraient être apportées aux modes de réalisation décrits ou représentés. Ainsi plusieurs sources de courant commandables pouvant être connectées au collecteur du transistor $T_1$, par exemple pour réaliser un générateur de courant à niveaux multiples (positifs, négatifs, ou nul), ou bien encore la source de courant commandable connectée au collecteur du transistor $T_1$ peut dans le même but présenter elle-même plusieurs niveaux de courant (LC étant susceptible de fournir plusieurs niveaux de tension à la base de $T_{40}$).

## Revendications

1. Circuit intégré comprenant un générateur de courant commutable présentant un premier état de fourniture de courant et un deuxième état de haute impédance, lequel générateur comporte un premier étage comprenant un miroir de courant (T3, T4) présentant une première et une deuxième branches fournissant respectivement un premier et un deuxième courant sensiblement de même intensité et un deuxième étage, du type différentiel, et comportant un premier ($T_1$) et un deuxième ($T_2$) transistor de type npn dont les émetteurs sont connectés entre eux ainsi qu'à une première source de courant d'intensité donnée ($R_{10}$, $T_{10}$) et dont les collecteurs sont connectés respectivement auxdites première et deuxième branches du miroir de courant, le collecteur du premier transistor ($T_1$) constituant la sortie du générateur de courant commutable; le générateur comporte également une deuxième source de courant commandable ($R_{20}$, $T_{20}$) ayant sensiblement la même intensité que la première source de courant et présentant un troisième transistor de type npn et connectée aux émetteurs des premier ($T_1$) et deuxième ($T_2$) transistors, ladite deuxième source de courant présentant un état de fourniture de courant et un état inactif; le générateur comporte en outre un circuit de commutation (LC) agencé pour, dans le premier état, mettre la deuxième source de courant ($R_{20}$, $T_{20}$) en état inactif, et pour déséquilibrer le deuxième étage de manière à ce que le premier transistor ($T_1$) soit pratiquement en état de non-conduction et dans le deuxième état, mettre la deuxième source de courant ($R_{20}$, $T_{20}$) en état de fourniture de courant, et mettre le deuxième étage en état d'équilibre.

2. Circuit selon la revendication 1 caractérisé en ce que les bases des premier et deuxième transistors sont reliées à une source de tension de référence ($V_{REF}$) à travers respectivement une première ($R_1$) et une deuxième ($R_2$) résistance, en ce qu'il comporte une troisième source de courant (R30, T30) commandable connectée à la base du premier transistor ($T_1$)

et présentant un état de fourniture de courant et un état inactif, et en ce que le circuit de commutation (LC) comporte un moyen pour commander la troisième source de courant de manière à la mettre à son état de fourniture de courant dans ledit premier état, et dans son état inactif dans ledit deuxième état.

3. Circuit selon une des revendications précédentes, caractérisé en ce que, pour une commutation selon trois états, le circuit de commutation présente une quatrième source de courant $(R_{40}, T_{40})$ commandable de type npn présentant un état de fourniture de courant et un état inactif, et connectée au collecteur du premier transistor $(T_1)$.

4. Circuit selon la revendication 3, caractérisé en ce que le circuit de commutation est agencé pour que dans le troisième état la deuxième $(R_{20}, T_{20})$ et la quatrième source de courant $(R_{40}, T_{40})$ soient en état de fourniture de courant et le deuxième étage soit en état d'équilibre.

5. Circuit selon la revendication 4, caractérisé en ce que le courant de la quatrième source de courant $(R_{40}, T_{40})$ est sensiblement égal à celui de la première source de courant $(R_{10}, T_{10})$.

6. Circuit selon la revendication 3, caractérisé en ce que le circuit de commutation est agencé pour que, dans le troisième état, la deuxième source de courant soit en état inactif, que le deuxième étage soit en état de déséquilibre, et que la quatrième source de courant $(R_{40}, T_{40})$ soit en état de fourniture de courant.

7. Circuit selon la revendication 6, caractérisé en ce que le courant de la quatrième source de courant $(R_{40}, T_{40})$ est sensiblement égal au double de celui de la première source de courant $(R_{10}, T_{10})$.

8. Circuit selon une des revendications précédentes caractérisé en ce qu'au moins une source de courant commandable est un convertisseur numérique-analogique à transistors npn et à sortie en courant.

**Claims**

1. An integrated circuit comprising a switchable current generator having at least a first or current-supply mode and a second or high-impedance mode, which generator comprises a first stage comprising a current mirror $(T_3,$ $T_4)$ having a first and a second branch, supplying a substantially equal first and second current respectively, and a second stage of the differential type comprising a first $(T_1)$ and a second $(T_2)$ transistor of the npn type whose emitters are connected to each other and to a first source $(R_{10}, T_{10})$ of current of given magnitude, and whose collectors are connected respectively to said first and said second branch of the current mirror, the collector of the first transistor $(T_1)$ forming the output of the switchable current generator; which generator also comprises a controllable second current source $(R_{20}, T_{20})$ whose current is substantially equal to that of the first current source and comprising a third transistor of the npn type connected to the emitters of the first $(T_1)$ and the second $(T_2)$ transistor, said second current source having a current-supply state and an inoperative state; which generator further comprises a switching circuit (LC) constructed for, in the first mode, setting the second current source $(R_{20}, T_{20})$ to the inoperative state and unbalancing the second stage in a such a manner that the first transistor $(T_1)$ is substantially non-conductive and, in the second mode, setting the second current source $(R_{20}, T_{20})$ to the current supply state and balancing the second stage.

2. A circuit as claimed in Claim 1, characterized in that the bases of the first and the second transistor are connected to a reference voltage $(V_{REF})$ source *via* a first $(R_1)$ and a second $(R_2)$ resistor respectively, in that it comprises a controllable third current source $(R_{30}, T_{30})$ connected to the base of the first transistor $(T_1)$ and having a current supply state and an inoperative state, and in that the switching circuit (LC) comprises a means for controlling the third current source so as to set it to its current supply state in said first mode and to its inoperative state in said second mode.

3. A circuit as claimed in any one of the preceding Claims, characterized in that, for the purpose of switching to three nodes, the switching circuit comprises a controllable npn-type fourth current source $(R_{40}, T_{40})$ having a current supply state and an inoperative state and connected to the collector of the first transistor $(T_1)$.

4. A circuit as claimed in Claim 3, characterized in that the switching circuit is adapted in such a manner that in the third mode the second $(R_{20}, T_{20})$ and the fourth $(R_{40}, T_{40})$ current source are in the current supply state and the second stage is in the balanced state.

**5.** A circuit as claimed in Claim 4, characterized in that the current of the fourth current source ($R_{40}$, $T_{40}$) is substantially equal to that of the first current source ($R_{10}$, $T_{10}$).

**6.** A circuit as claimed in Claim 3, characterized in that the switching circuit is adapted in such a manner that in the third mode the second current source is in the inoperative state, the second stage is in the unbalanced state, and the fourth current source ($R_{40}$, $T_{40}$) is in the current supply state.

**7.** A circuit as claimed in Claim 6, characterized in that the current of the fourth current source ($R_{40}$, $T_{40}$) is substantially equal to twice that of the first current source ($R_{10}$, $T_{10}$).

**8.** A circuit as claimed in any one of the preceding Claims, characterized in that at least one controllable current source is a digital-to-analog converter comprising npn transistors and having a current output.

**Patentansprüche**

**1.** Integrierte Schaltung mit einem schaltbaren Stromquellengenerator mit wenigstens einem ersten Stromversorgungszustand und einem zweiten Hochimpedanzzustand, und dieser Generator enthält eine erste Stufe mit einem Stromspiegel (T3, T4) mit einer ersten und einem zweiten Zweig, die einen ersten und einen zweiten Strom im wesentlichen mit derselben Stärke liefern, und eine zweite differentielle Stufe mit einem ersten ($T_1$) und einem zweiten Transistor ($T_2$) vom npn-Typ enthält, deren Emitter miteinander und mit einer ersten Stromquelle zum Ausgeben eines Stroms mit vorgegebener Größe verbunden sind und deren Kollektoren mit dem ersten bzw. dem zweiten Zweig des Stromspiegels verbunden sind, der Kollektor des ersten Transistors einen Ausgang des schaltbaren Stromgenerators bildet, daß er ebenfalls eine steuerbare zweite Stromquelle ($R_{20}$, $T_{20}$) mit im wesentlichen dieselbe Stärke wie die erste Stromquelle und mit einem dritten Transistor vom npn-Typ enthält, der mit den Emittern der ersten und zweiten Transistoren verbunden ist, die zweite Stromquelle einen Stromversorgungszustand und einen betriebslosen Zustand hat, daß er außerdem einen Schaltkreis (LC) enthält, der derart aufgebaut ist, daß im ersten Zustand die zweite Stromquelle ($R_{20}$, $T_{20}$) in den betriebslosen Zustand gebracht wird und die zweite Stufe derart unsymmetrisch gemacht wird, daß der erste Transistor ($T_1$) im wesentlichen gesperrt bleibt, und im zweiten Betriebszustand die zweite Stromquelle ($R_{20}$, $T_{20}$) in den Stromversorgungszustand und die zweite Stufe in den Gleichgewichtszustand gebracht wird.

**2.** Schaltung nach Anspruch 1, dadurch gekennzeichnet, daß die Basen des ersten und des zweiten Transistors mit einer Bezugsspannungsquelle ($V_{REF}$) über einen ersten ($R_1$) bzw. einen zweiten Widerstand ($R_2$) verbunden sind, daß der Generator eine steuerbare dritte Stromquelle vom npn-Typ in Verbindung mit der Basis des ersten Transistors ($T_1$), einen Stromversorgungszustand und einen betriebslosen Zustand enthält, und daß der Schaltkreis (LC) ein Mittel zum Steuern der dritten Stromquelle zum Setzen dieser Stromquelle in ihren Stromversorgungszustand im ersten Betrieb und in ihren betriebslosen Zustand im zweiten Betrieb enthält.

**3.** Schaltung nach einem der vorangehenden Ansprüche, dadurch gekennzeichnet, daß für einen Dreizuständebetrieb der steuerbare Schaltkreis vom npn-Typ eine vierte Stromquelle ($R_{40}$, $T_{40}$) mit einem Stromversorgungszustand und einem betriebslosen Zustand in Verbindung mit dem Kollektor des ersten Transistors ($T_1$) enthält.

**4.** Schaltung nach Anspruch 3, dadurch gekennzeichnet, daß der Schaltkreis derart ausgelegt ist, daß in der dritten Betriebsart die zweite ($R_{20}$, $T_{20}$) und die vierte Stromquelle ($R_{40}$, $T_{40}$) sich im Stromversorgungszustand befinden und die zweite Stufe symmetrisch ist.

**5.** Schaltung nach Anspruch 4, dadurch gekennzeichnet, daß der Strom der vierten Stromquelle ($R_{40}$, $T_{40}$) im wesentlichen gleich dem Strom der ersten Stromquelle ($R_{10}$, $T_{10}$) ist.

**6.** Schaltung nach Anspruch 3, dadurch gekennzeichnet, daß der steuerbare Schaltkreis derart ausgelegt ist, daß im dritten Zustand die zweite Stromquelle im betriebslosen Zustand steht, daß die zweite Stufe im unsymmetrischen Zustand steht, unddaß die vierte Stromquelle ($R_{40}$, $T_{40}$) im Stromversorgungszustand steht.

**7.** Schaltung nach Anspruch 6, dadurch gekennzeichnet, daß der Strom der vierten Stromquelle ($R_{40}$, $T_{40}$) im wesentlichen gleich dem doppelten Stromwert der ersten Stromquelle ($R_{10}$, $T_{10}$) ist.

8.  Schaltung nach einem oder mehreren der vorangehenden Ansprüche, dadurch gekennzeichnet, daß wenigstens eine steuerbare Stromquelle ein Digital/Analogwandler mit npn-Transistoren und mit einem Stromausgang ist.

FIG.1

FIG.2